# EUROPEAN PATENT SPECIFICATION

(11) **EP 2 480 059 B1**
(45) Date of publication and mention of the grant of the patent: **20.11.2013**
(21) Application number: 11152127.4
(22) Date of filing: 25.01.2011
(51) Int. Cl.: H05K 5/00, H05K 5/02

(54) **Improvements in or relating to the production of an electronic unit, such as a sensor unit for a motor vehicle safety device**
Verbesserungen von oder in Bezug auf die Herstellung einer elektronischen Einheit, wie z.B. eine Sensoreinheit für eine Motorfahrzeug-Sicherheitsvorrichtung
Améliorations de ou associées à la production d'une unité électronique, telle qu'une unité de capteur pour dispositif de sécurité de véhicule à moteur

(43) Date of publication of application: 25.07.2012
(73) Proprietor: AUTOLIV DEVELOPMENT AB, 447 83 Vargarda (SE)
(72) Inventor: Tartrou, Jean-Francois, 78700 Confians Sainte Honorine (FR)
(74) Representative: Parry, Simon James

(56) References cited:
- EP-A2- 0 862 354
- US-A1- 2010 079 934
- US-B1- 7 048 564

## Description

The present invention relates to a method of producing an electronic unit, and more particularly relates to a method of producing an electronic sensor unit for a motor vehicle safety device. Another aspect of the invention relates to an associated sensor unit.

Modern motor vehicle safety systems typically comprise a number of sensor units which are configured to sense and detect the occurrence or likely occurrence of accidents such as crashes or other impacts involving the motor vehicle. A typical sensor unit of this type comprises one or more sensors responsive to acceleration. The sensors are mounted to a printed circuit board which is mounted inside a housing, the housing typically being moulded of plastics material.

As will be appreciated, printed circuit boards (and indeed the various components mounted to such boards in an impact sensor) are very delicate and are hence susceptible to damage if they are not adequately protected inside the housing. In order to ensure that the circuit board is securely mounted within the housing of the sensor unit, it is therefore common practice to fill a space within the housing adjacent the circuit board with potting material. The potting material is typically a heat-curable plastics material which is injected into the space adjacent the circuit board in liquid form and which is then cured via the application of heat. Alternatively, the potting material may comprise an epoxy resin mixed with a curing agent. The use of either type of potting material results in the generation of heat as it is cured, and the heat can produce gases. These gases must be allowed to vent from the housing before the potting material becomes significantly cured; otherwise they can cause bubbles in the potting material thereby comprising the effectiveness of the potting material in sealing the circuit board within the housing. It has therefore been proposed previously to provide the housing with a vent hole to permit the gases to vent from the housing as the potting material is cured.

It is desirable to provide the vent hole in a position which will not be exposed to water or substantial moisture during use of the sensor unit, because of course in such a situation the water or moisture could otherwise penetrate the housing via the vent hole. It has therefore been proposed previously to provide the vent hole within a female connector part of the housing which is configured to receive a male connector for electrical connection to the circuit board. In arrangements of this type, the vent hole becomes covered when the male connector is fully inserted into the female connector part of the sensor housing.

Nevertheless, arrangements of the type described above are often ineffective at preventing the ingress of moisture, for example through exposure of the sensor to humid environments during the course of its lifetime. It is therefore desirable in some applications to further seal the vent hole itself in order to prevent the ingress of moisture in this manner. One way to achieve this is to fill the vent hole with sealant after the potting material has been cured, for example along a sealing conduit moulded into the sensor housing. However, this sort of proposal, and other similar proposals are inconvenient from a manufacturing point of view and can add cost to the production process.

It is therefore an object of the present invention to address these shortcomings of the prior art.

Accordingly, a first aspect of the present invention provides a method of producing an electronic unit comprising a circuit board mounted within a housing, the method comprising the steps of: providing a housing having a vent hole; inserting a circuit board into the housing; filling a space around or against the circuit board with a potting material; curing the potting material; permitting gas within the housing to vent from the housing through the vent hole during at least one of said filling and curing steps; and subsequently sealing said vent hole, the method being characterised in that sealing the vent hole is achieved via the application of a label to the outside of the housing, the label being applied so as to extend across the vent hole and thereby seal the hole from the ingress of moisture into the housing.

According to a second aspect of the present invention, there is provided a method of producing an electronic sensor unit for a motor vehicle safety device, the sensor unit comprising a circuit board mounted within a housing, and being produced by a method according to the first aspect of the invention.

According to a third aspect of the present invention, there is provided an electronic sensor unit for a motor vehicle safety device, the unit comprising a circuit board mounted within a housing having a space filled with potting material around or against the circuit board, the unit being characterised in that the housing has a vent hole which is sealed from the ingress of moisture by a label applied to the outside of the housing and which extends across the hole.

Preferably, the sensor unit is provided in the form of an impact sensor comprising an accelerometer mounted to the circuit board.

Advantageously, said label is used to seal said vent aperture substantially hermetically.

Conveniently, said label is a product label bearing indicia representative of the product identity and/or its operational characteristics.

Preferably, said label is adhesively secured to an outside surface of the housing.

Advantageously the label is self-adhesive.

Conveniently, the method of either the first or second aspects of the invention further comprises the step of filling the vent hole with adhesive before the application of said label.

Preferably, the vent hole is located in a substantially planar external surface of the housing, and wherein said label is affixed to said planar surface.

Advantageously, said substantially planar external surface and said label are both shaped and configured such that said label substantially covers said planar surface when affixed thereto.

Conveniently the method of either the first or second aspects of the invention further comprises the step of plugging said vent hole with a plug inserted from outside the housing prior to the application of said label.

Preferably, said label is applied over said plug so as to retain the plug in position within said vent hole.

Advantageously, said plug takes the form of a screw-threaded element and wherein said step of plugging the vent hole comprises threadedly engaging said element within said vent hole.

So that the invention may be more readily understood, and so that further features thereof may be appreciated, embodiments of the invention will now be described by way of example with reference to the accompanying drawings in which:
Figure 1 is a perspective view, from above and one end, of a sensor housing and a printed circuit board generally in accordance with an embodiment of the present invention;
Figure 2 is another perspective view, from a slightly different angle, showing further internal detail of the sensor housing;
Figure 3 is a perspective view of the housing from above and the opposite end;
Figure 4 is a schematic cross-sectional view through the housing showing an initial step in the production of the sensor unit;
Figure 5 is a view corresponding generally to that of figure 4, but which shows a subsequent step in the production process;
Figure 6 shows a further step in the production process;
Figure 7 shows a another subsequent step in the production process;
Figure 8 is a view generally corresponding to that of figure 3, but which shows the sensor after the production step of figure 7; and
Figure 9 is a schematic cross-sectional view showing an additional optional step in the production method of the present invention.

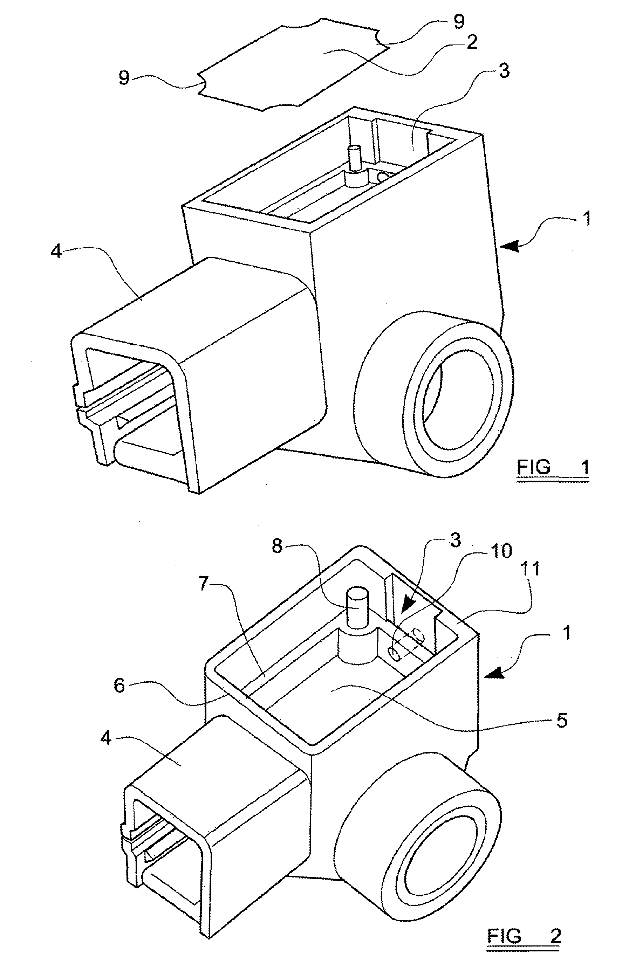

Turning firstly to consider figure 1, there are illustrated a sensor housing 1 and a printed circuit board 2 prior to assembly to form a completed electronic sensor unit, such as an impact sensor for a motor vehicle safety arrangement. The housing 1 is preferably moulded from plastics material and defines an upwardly open cavity 3 configured to receive the printed circuit board 2. One end of the housing carries a female connector part 4 which is configured to slidingly receive a correspondingly formed male connector (not shown) in order to electrically connect the sensor unit to the circuitry of a safety arrangement in a manner known *per* se.

Figure 2 shows the housing 1 viewed from a different angle, and in particular shows the inner configuration of the cavity 3 in more detail. As will be noted, the cavity 3 is generally rectangular in form, and is shown open in figure 2, ready for the receipt of the circuit board 2. The cavity 3 has a bottom surface 5 which is spaced below the upper edge 6 of the housing. A mounting shoulder 7 is formed around the outer periphery of the bottom surface 5 at a position spaced between the bottom surface 5 and the upper edge 6 of the housing. The shoulder is formed in the manner of a step projecting inwardly of the cavity 3 from the peripheral upstanding sidewalls defined around the cavity.

In each corner of the cavity 3 there is provided a respective mounting post 8 (only one of which is visible in figure 2) extending vertically upwardly from the shoulder 7. Each mounting post 8 may be provided with an internally screw-threaded bore to threadedly receive a respective fixing screw (not shown) used to secure a cover plate (not shown) over the cavity 3 in a manner known *per se* when the sensor is otherwise fully assembled. As will be noted from figure 1, the circuit board 2 is generally rectangular in form, having a shape corresponding generally to that of the cavity 3, for receipt therein. However, the corners of the circuit board are each provided with arcuate cut-outs 9, each cut-out 9 being configured to fit around a respective mounting post 8.

Importantly, the housing 1 is provided with a vent hole 10 which extends through the housing at a position between the bottom surface 5 of the cavity 3 and the mounting shoulder 7 and which serves to permit the flow of gas from the cavity 3 to the atmosphere. As illustrated in figure 2, the vent hole 10 is provided through the end wall 11 of the housing which is opposed to the female connector part 4 and moulded as an integral part of the housing. In the event that the wall of the housing in which the vent hole 10 is formed has significant thickness, the vent hole will take the form of an elongate bore therethrough. As will be appreciated, because the housing 1 is moulded in a single piece, a removable tool is required in order to mould the vent hole 10 through the end wall 11. It is proposed that the toll will be provided in the form of a slide insert which is positioned to define the vent hole 10 as the housing is moulded, and which is slideably retracted from the vent hole 10 before the housing 1 is removed from the mould.

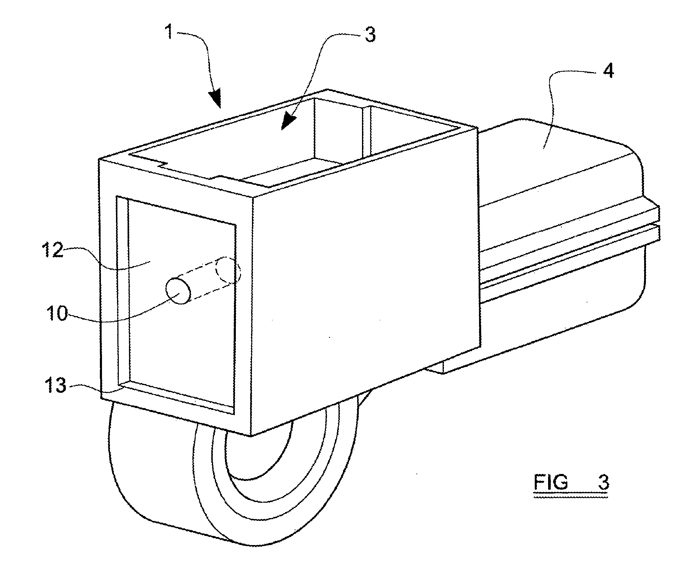

Figure 3 shows the sensor housing 1 as viewed from the end in which the vent hole 10 is formed. As will be noted, in the embodiment illustrated the vent hole 10 opens in a generally central region of a substantially planar external surface 12 of the housing 1. In the particular arrangement illustrated in figure 3, it will furthermore be noted that the housing is configured such that the planar external surface 12 is substantially rectangular and is recessed slightly from the extreme end of the housing so as to define a peripheral lip 13 around the surface 12.

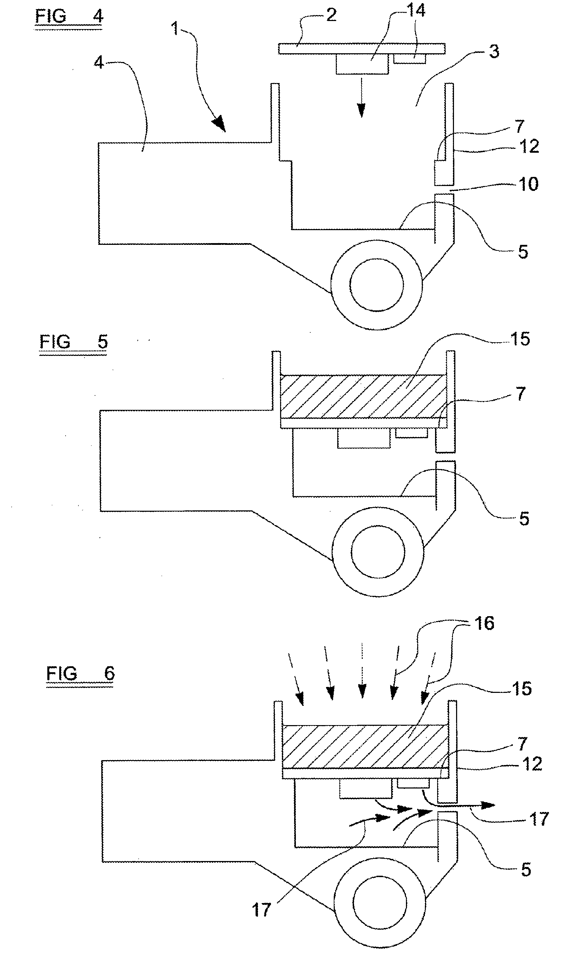

Assembly of a sensor unit in accordance with the invention will now be described with reference to figures 4 to 9 of the accompanying drawings.

Figure 4 shows the circuit board 2 being inserted downwardly into the cavity 3 through the opening at the top of the cavity. As will be noted, the circuit board 2 carries a number of electronic components 14 which may include, for example, an accelerometer in a generally conventional manner. In the arrangement illustrated, the circuit board 2 is inserted into the cavity 3 of the housing with its components 14 facing downwardly towards the bottom surface 5 of the cavity 3. This is currently favoured for the production of impact sensors, although it should be appreciated that in variants of the invention the circuit board can instead be inserted into the cavity in the reverse orientation such that its components 14 sit on top of the circuit board and hence face away from the bottom surface 5.

The circuit board 2 is inserted into the cavity as illustrated so that its peripheral edge-regions sit on the inwardly directed mounting shoulder 7. In this position the electronic components 14 mounted on the circuit board are supported in spaced relation to the bottom surface 5 of the cavity 3. When the circuit board 2 is properly inserted in this position, it is then fixed in position by filling the region of the cavity 3 above the circuit board 2 with potting material 15 as illustrated schematically in figure 5. The potting material 15 can take any convenient form known in the art. For example, the potting material 15 may be of a type which is cured by the application of heat, or may alternatively be of a sort which hardens due to the mixture of several constituents. In either case, the potting material is injected into the cavity 3 in liquid form and so will flow over the circuit board 2 and around the edge regions of the circuit board sitting on the shoulder 7.

When sufficient potting material 15 has been injected into the cavity 3 above the circuit board, it is cured so as to harden and securely fix and seal the circuit board 2 in position within the housing 1. Regardless of whether the potting material 15 requires the addition of external heat energy to cure (as illustrated schematically by arrows 16 in figure 6), or hardens due to mixture together of different constituents, heat will be generated in the potting material. This generation of heat creates gases within the cavity 3. Gases formed in the upper part of the cavity 3, above the circuit board 2, can of course naturally escape through the top opening of the cavity 3 through which the circuit board 2 was inserted.

The vent hole 10 permits gases created in the lower part of the cavity 3, below the circuit board 2, to vent through the end wall 11 of the housing (as illustrated schematically by arrows 17 in figure 6) in preference to escaping through the potting material 15 which could result in the creation of air bubbles in the potting material which could become trapped as it cures.

As will be appreciated, when the potting material 15 is fully cured the vent hole 10 is no longer required to perform its function of venting gases from the cavity 3. For applications of the sensor where it is important to prevent moisture from entering the sensor unit, the vent hole 10 must therefore then be sealed. For example, where the sensor unit may be required to operate in a humid environment where there is much water vapour in the air, sealing the vent hole 10 is important to prevent the moisture from penetrating the sensor housing and damaging the sensitive components inside.

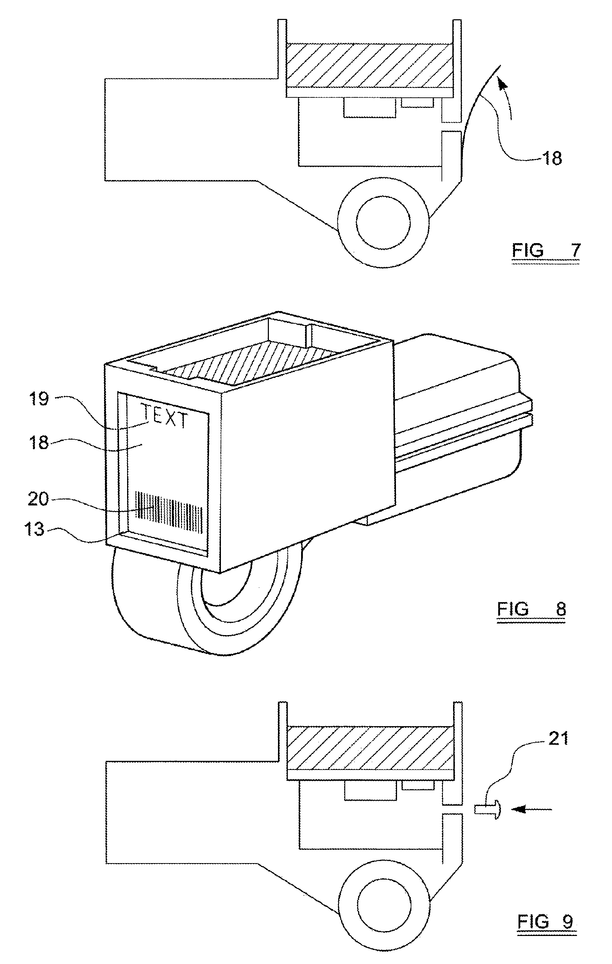

Figure 7 shows the step of sealing the vent hole 10 after the potting material 15 has substantially fully cured. A label 18 is illustrated being applied to the planar external surface 12 of the housing, so as to extend over the vent hole 10, thereby sealing the hole and preventing the ingress of moisture into the housing. The label is preferably substantially impermeable to air and may be affixed to the surface 12 via adhesive, and indeed in some embodiments it is envisaged that the adhesive itself may be used to fill the vent hole 12 before the application of the label 18. However, in other embodiments it is envisaged that the label will be self-adhesive and hence conveniently affixed to the surface 12 of the housing over the vent hole in a simple and inexpensive manner. In either case, it is envisaged that the label will be affixed in a manner which is effective to substantially hermetically seal the vent hole 10, thereby preventing the passage of moisture, even in vapour form, through the hole.

Figure 8 shows the label 18 in position over the vent hole 10. As will be noted, the label is substantially rectangular in form and is hence configured to substantially fully cover the planar surface 12 of the housing, neatly fitting inside the peripheral lip 13. The label 18 may take the form of a product label carrying surface indicia (such as text 19 and/or a barcode 20) representative of the product identity and/or its operational characteristics or the like.

Figure 9 illustrates an optional additional step in the assembly of the sensor unit, and shows the insertion of a plug 21 into the vent hole 10 from outside the housing after the potting material 15 has been cured but prior to the application of the label 18. It is envisaged that the plug may be externally screw-threaded and thus is threadedly engaged inside the vent hole 15, either via engagement with a correspondingly formed internal screw thread in the vent hole, or in a self-tapping manner. Alternatively, however, the plug 21 may be press-fitted into the hole as an interference fit. As will be appreciated, the plug 21 will serve to substantially seal the vent hole, and subsequent application of the label 18 over the plug in a similar manner to that described above will serve to further seal the hole and also to retain the plug securely in position. Alternatively, it is envisaged that the plug 21 may be overmoulded, either partially or entirely, after insertion onto the vent hole 10 in order to retain the plug 21 in position.

When used in this specification and claims, the terms "comprises" and "comprising" and variations thereof mean that the specified features, steps or integers are included. The terms are not to be interpreted to exclude the presence of other features, steps or integers.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the scope of the invention.

## Claims

1. A method of producing an electronic unit comprising a circuit board (2) mounted within a housing (1), the method comprising the steps of: providing a housing (1) having a vent hole (10); inserting a circuit board (2) into the housing; filling a space (3) around or against the circuit board with a potting material (15); curing the potting material; permitting potting material curing heat gas within the housing to vent from the housing through the vent hole during at least one of said filling and curing steps; and sealing said vent hole, the method being **characterised in that** sealing the vent hole is achieved via the application of a label (18) to the outside of the housing, the label being applied so as to extend across the vent hole and thereby seal the hole from the ingress of moisture into the housing.

2. A method according to claim 1, wherein said label (18) is used to seal said vent hole (10) hermetically.

3. A method according to claim 1 or claim 2, wherein said label (18) is a product label bearing indicia (19, 20) representative of the product identity and/or its operational characteristics.

4. A method according to any preceding claim, wherein said label (18) is adhesively secured to an outside surface (12) of the housing (1).

5. A method according to any preceding claim, wherein the label (18) is self-adhesive.

6. A method according to claim 5, further comprising the step of filling the vent hole (10) with adhesive before the application of said label.

7. A method according to any preceding claim, wherein the vent hole (10) is located in a planar external surface (12) of the housing, and wherein said label is affixed to said planar surface.

8. A method according to claim 7, wherein said substantially planar external surface (12) and said label (18) are both shaped and configured such that said label covers said planar surface when affixed thereto.

9. A method according to any preceding step, further comprising the step of plugging said vent hole (10) with a plug (21) inserted from outside the housing prior to the application of said label (18).

10. A method according to claim 9, wherein said label (18) is applied over said plug (21) so as to retain the plug in position within said vent hole.

11. A method according to claim 9 or claim 10, wherein said plug (21) takes the form of a screw-threaded element and wherein said step of plugging the vent hole (10) comprises threadedly engaging said element within said vent hole.

12. A method of producing an electronic sensor unit for a motor vehicle safety device, the sensor unit comprising a circuit board (2) mounted within a housing (1), and being produced by a method according to any preceding claim.

13. A method according to claim 12, wherein the sensor unit is an impact sensor unit comprising an accelerometer (14) mounted to the circuit board (20.

14. An electronic sensor unit for a motor vehicle safety device, the unit comprising a circuit board (2) mounted within a housing (1) having a space (3) filled with potting material (15) around or against the circuit board, wherein the housing has a vent hole (100) permitting potting material curing heat gas to vent and sealed, from the ingress of moisture after curing, by a label (18) applied to the outside of the housing and which extends across the hole.

15. An electronic sensor unit according to claim 14 provided in the form of an impact sensor comprising an accelerometer (14) mounted to the circuit board (2).

## Patentansprüche

1. Verfahren zum Herstellen einer elektronischen Einheit, die eine Platine (2) umfasst, die in einem Gehäuse (1) untergebracht ist, wobei das Verfahren folgende Schritte umfasst: Bereitstellen eines Gehäuses (1), das eine Entlüftungsöffnung (10) aufweist; Einsetzen einer Platine (2) in das Gehäuse; Füllen eines Raums (3) um die Platine herum oder an der Platine mit einer Vergussmasse (15); Aushärten der Vergussmasse; Zulassen, dass Wärmegas vom Aushärten der Vergussmasse innerhalb des Gehäuses während des Füll- und/oder Aushärtungsschritts durch die Entlüftungsöffnung aus dem Gehäuse abzieht; und Abdichten der Entlüftungsöffnung, wobei das Verfahren **dadurch gekennzeichnet ist, dass** das Abdichten der Entlüftungsöffnung über das Aufbringen eines Etiketts (18) an der Außenseite des Gehäuses erfolgt, wobei das Etikett so aufgebracht wird, dass es sich über die Entlüftungsöffnung erstreckt und dadurch die Öffnung gegen das Eindringen von Feuchtigkeit in das Gehäuse abdichtet.

2. Verfahren nach Anspruch 1, wobei das Etikett (18) verwendet wird, um die Entlüftungsöffnung (10) hermetisch abzudichten.

3. Verfahren nach Anspruch 1 oder Anspruch 2, wobei das Etikett (18) ein Produktetikett ist, das Angaben (19, 20) enthält, die für die Bezeichnung des Produkts und/oder seine Betriebskenndaten stehen.

4. Verfahren nach einem vorhergehenden Anspruch, wobei das Etikett (18) haftend an einer Außenfläche (12) des Gehäuses (1) befestigt wird.

5. Verfahren nach einem vorhergehenden Anspruch, wobei das Etikett (18) selbstklebend ist.

6. Verfahren nach Anspruch 5, das ferner den Schritt des Füllens der Entlüftungsöffnung (10) mit Klebstoff vor dem Aufbringen des Etiketts umfasst.

7. Verfahren nach einem vorhergehenden Anspruch, wobei sich die Entlüftungsöffnung (10) in einer ebenen Außenfläche (12) des Gehäuses befindet und wobei das Etikett an der ebenen Fläche angebracht wird.

8. Verfahren nach Anspruch 7, wobei die im Wesentlichen ebene Außenfläche (12) und das Etikett (18) beide so geformt und eingerichtet sind, dass das Etikett die ebene Fläche bedeckt, wenn es daran angebracht wird.

9. Verfahren nach einem vorhergehenden Anspruch, das ferner den Schritt des Verschließens der Entlüftungsöffnung (10) mit einem Stopfen (21) umfasst, der vor dem Aufbringen des Etiketts (18) von außerhalb des Gehäuses eingesetzt wird.

10. Verfahren nach Anspruch 9, wobei das Etikett (18) über dem Stopfen (21) aufgebracht wird, um den Stopfen in der Entlüftungsöffnung festzuhalten.

11. Verfahren nach Anspruch 9 oder Anspruch 10, wobei der Stopfen (21) die Form eines mit einem Schraubgewinde versehenen Elements annimmt und wobei der Schritt des Verschließens der Entlüftungsöffnung (10) das Einschrauben des Elements in die Entlüftungsöffnung umfasst.

12. Verfahren zum Herstellen einer elektronischen Sensoreinheit für eine Motorfahrzeug-Sicherheitsvorrichtung, wobei die Sensoreinheit eine Platine (2) umfasst, die in einem Gehäuse (1) untergebracht ist, und mit einem Verfahren nach einem vorhergehenden Anspruch hergestellt wird.

13. Verfahren nach Anspruch 12, wobei es sich bei der Sensoreinheit um eine Aufprallsensoreinheit handelt, die einen Beschleunigungssensor (14) umfasst, der an der Platine (20) angebracht ist.

14. Elektronische Sensoreinheit für eine Motorfahrzeug-Sicherheitsvorrichtung, wobei die Einheit eine Platine (2) umfasst, die in einem Gehäuse (1) untergebracht ist, das einen Raum (3) aufweist, der um die Platine herum oder an der Platine mit Vergussmasse (15) gefüllt ist, wobei das Gehäuse eine Entlüftungsöffnung (100) aufweist, die ermöglicht, dass Wärmegas vom Aushärten der Vergussmasse abzieht, und mit einem Etikett (18), das an der Außenseite des Gehäuses angebracht ist und das über die Öffnung verläuft, gegen das Eindringen von Feuchtigkeit nach dem Aushärten abgedichtet ist.

15. Elektronische Sensoreinheit nach Anspruch 14, die in Form eines Aufprallsensors vorgesehen ist, der einen Beschleunigungssensor (14) umfasst, der an der Platine (2) angebracht ist.

## Revendications

1. Procédé de production d'une unité électronique comprenant une carte de circuit imprimé (2) montée dans un boîtier (1), le procédé comprenant les étapes consistant à : fournir un boîtier (1) présentant un trou d'évent (10) ; insérer une carte de circuit imprimé (2) dans le boîtier ; remplir un espace (3) autour de ou contre la carte de circuit imprimé avec un matériau de remplissage (15) ; durcir le matériau de remplissage ; permettre à du gaz chaud de durcissement de matériau de remplissage dans le boîtier de s'échapper du boîtier à travers le trou d'évent pendant au moins l'une desdites étapes de remplissage et de durcissement ; et obturer le trou d'évent, le procédé étant **caractérisé en ce que** l'obturation du trou d'évent est obtenue par l'application d'une étiquette (18) sur l'extérieur du boîtier, l'étiquette étant appliquée de façon à s'étendre en travers du trou d'évent et obturer ainsi le trou pour empêcher la pénétration d'humidité dans le boîtier.

2. Procédé selon la revendication 1, dans lequel ladite étiquette (18) est utilisée pour obturer ledit trou d'évent (10) de manière hermétique.

3. Procédé selon la revendication 1 ou la revendication 2, dans lequel ladite étiquette (18) est une étiquette de produit portant des indications (19, 20) représentant l'identité du produit et/ou ses caractéristiques de fonctionnement.

4. Procédé selon une quelconque revendication précédente, dans lequel ladite étiquette (18) est fixée par adhérence sur une surface extérieure (12) du boîtier (1).

5. Procédé selon une quelconque revendication précédente, dans lequel l'étiquette (18) est auto-adhésive.

6. Procédé selon la revendication 5, comprenant en outre l'étape de remplissage du trou d'évent (10) avec un adhésif avant l'application de ladite étiquette.

7. Procédé selon une quelconque revendication précédente, dans lequel le trou d'évent (10) est situé dans une surface extérieure plane (12) du boîtier, et dans lequel ladite étiquette est fixée sur ladite surface plane.

8. Procédé selon la revendication 7, dans lequel ladite surface extérieure essentiellement plane (12) et ladite étiquette (18) sont toutes les deux formées et configurées de façon à ce que ladite étiquette recouvre ladite surface plane quand elle est fixée sur celle-ci.

9. Procédé selon une quelconque étape précédente, comprenant en outre l'étape consistant à boucher ledit trou d'évent (10) avec un bouchon (21) inséré de l'extérieur du boîtier avant l'application de ladite étiquette (18).

10. Procédé selon la revendication 9, dans lequel ladite étiquette (18) est appliquée sur ledit bouchon (21) de façon à maintenir le bouchon en position dans ledit trou d'évent.

11. Procédé selon la revendication 9 ou la revendication 10, dans lequel ledit bouchon (21) prend la forme d'un élément fileté et dans lequel ladite étape consistant à boucher le trou d'évent (10) comprend le vissage dudit élément dans ledit trou d'évent.

12. Procédé de production d'une unité de capteur électronique pour un dispositif de sécurité de véhicule à moteur, l'unité de capteur comprenant une carte de circuit imprimé (2) montée dans un boîtier (1) et étant produite par un procédé selon une quelconque revendication précédente.

13. Procédé selon la revendication 12, dans lequel l'unité de capteur est une unité de capteur d'impact comprenant un accéléromètre (14) monté sur la carte de circuit imprimé (20).

14. Unité de capteur électronique pour un dispositif de véhicule à moteur, l'unité comprenant une carte de circuit imprimé (2) montée dans un boîtier (1) présentant un espace (3) rempli avec du matériau de remplissage (15) autour de ou contre la carte de circuit imprimé, dans lequel le boîtier présente un trou d'évent (100) permettant à du gaz chaud de durcissement de matériau de remplissage de s'échapper, et est obturé par une étiquette (18) appliquée sur l'extérieur du boîtier et qui s'étend en travers du trou pour empêcher la pénétration d'humidité après le durcissement.

15. Unité de capteur électronique selon la revendication 14 mise à disposition sous forme d'un capteur d'impact comprenant un accéléromètre (14) monté sur la carte de circuit imprimé (2).
